# EUROPEAN PATENT SPECIFICATION

(11) **EP 1 641 038 B1**
(45) Date of publication and mention of the grant of the patent: **10.08.2011**
(21) Application number: 05447213.9
(22) Date of filing: 21.09.2005
(51) Int. Cl.: H01L 21/78

(54) **Method for chip singulation**
Verfahren zur Trennung von Chips
Procédé pour séparer des puces

(30) Priority: 24.09.2004 US 612915 P; 09.12.2004 EP 04447271
(43) Date of publication of application: 29.03.2006
(73) Proprietor: IMEC, 3001 Leuven (BE)
(72) Inventor: Beyne, Eric, 3001 Leuven (BE); Swinnen, Bart, 3220 Holsbeek (BE); Vanhaelemeersch, Serge, 3001 Leuven (BE)
(74) Representative: pronovem

(56) References cited:
- US-A- 5 925 924
- US-A1- 2002 042 189
- US-B1- 6 214 745
- PATENT ABSTRACTS OF JAPAN vol. 008, no. 081 (E-238), 13 April 1984 (1984-04-13) -& JP 59 003961 A (NIPPON DENKI KK), 10 January 1984 (1984-01-10)
- LANDESBERGER C ET AL: "New dicing and thinning concept improves mechanical reliability of ultra thin silicon" ADVANCED PACKAGING MATERIALS: PROCESSES, PROPERTIES AND INTERFACES, 2001. PROCEEDINGS. INTERNATIONAL SYMPOSIUM ON MARCH 11-14, 2001, PISCATAWAY, NJ, USA,IEEE, 11 March 2001 (2001-03-11), pages 92-97, XP010539027 ISBN: 0-930815-64-5

## Description

### Field of the invention

The present invention relates to the field of semiconductor processing. More specifically it relates to methods for wafer dicing.

### State of the art

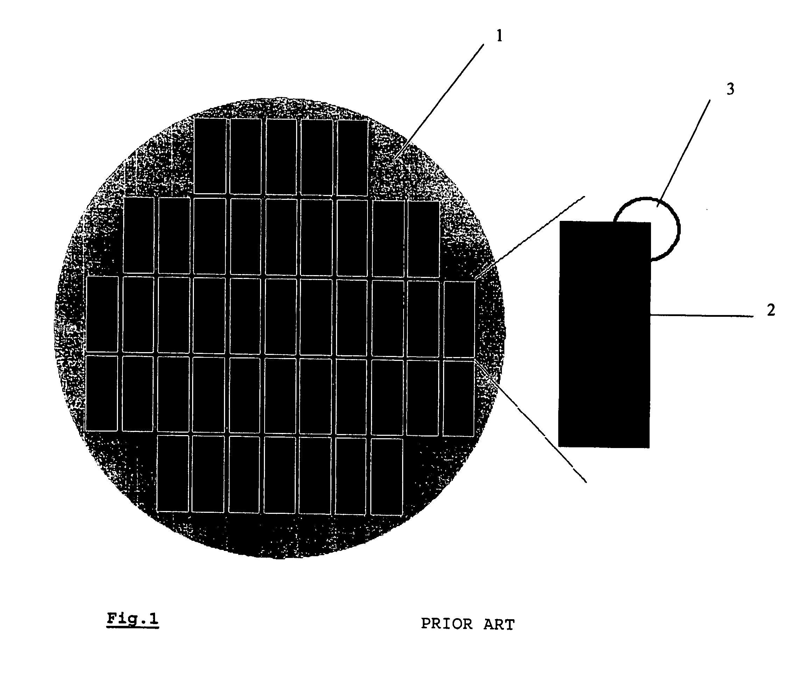

Die or chip singulation is the separation of different dies (2) on a wafer (1) (see Fig.1). It is the first of all assembly steps.

Die singulation by means of classical blade dicing is standard practice: dies are cut with a rotating wheel while a rinsing solution is spilled over the wafer in order to remove particles induced by the saw. This method requires dicing streets with a width of several tens of micron and gives rise to considerable sidewall damage (chipping, cracking). Especially when dicing through areas that contain metal dummies, which are present in copper damascene processing, the damage caused by ripping the metal pads out of the stack during dicing may be extensive.

Laser cutting is an alternative to classical blade dicing: here applying a laser beam onto it, evaporates material in the scribe lanes. This method is not subject to chipping. However, the heat generated by the laser beam may affect the properties of the material next to the dicing street. Hence an exclusion area where no circuitry is allowed is required near the dicing streets. Even without taking the heat-affected zone into account, the dicing streets achieved in this way are between 15 and 30 micron wide. No laser dicing solution exists that can cut through a stack with dummy metal pads in the scribe lanes.

Wafers or substrates are processed until completion of deposition, patterning and polishing of the last metal level below a passivation layer. A passivation layer is commonly known as a protective layer to assure the chemical stability of the layer(s) below. Both classical blade and laser dicing are performed after completion of the full wafer including passivation stack. Depending on the assembly route, a number of wafer level processes may be performed between passivation deposition and singulation (e.g. under bump metallisation (UBM) /solder plating/redistribution layer deposition).

Trench etch dicing is a known technique, for instance from Advanced Packaging Materials, Processes, Properties and Interfaces, Proceedings of IEEE 01TH8562, ISBN 0-930815-64-5, pp.92-97. Here, after completion of the wafer back end and the passivation stack, dicing streets are imaged and subsequently etched. This process gives rise to die edges that are very well defined (no chipping or cracking).

Trench etch dicing is capable of reducing considerably the scribe lane width required for dicing. In practice, the Si-gain is often limited by the fact that scribe lanes also contain electrical test structures and alignment features, which imposes a lower limit on the scribe lane width. Whereas blade dicing and laser dicing are performed scribe-by-scribe, trench etch dicing is a true wafer level process.

In all above processes, die singulation is performed after passivation. Hence: in all these processes, after singulation, only the top area of the die is passivated. Die edges are not protected.

In US-A-5925924 methods for precise definition of IC chip edges are disclosed. Trenches are etched in the wafer to define said edges. Then the trenches are filled with an insulating material, which mechanically joins the IC chips of the wafer. It should be noted that an insulating layer is not always a passivation layer. For certain applications however a passivation layer may be required. Moreover the patent describes a method for stacking different dies or ICs, which are interconnected via the side surface of the resulting stack. Different etching steps are necessary to achieve this goal, since a discontinuous isolation layer on at least one side surface of the stack is required to allow the formation of interconnects.

Patent US-A-5597766 relates to a method for detaching chips from a SOI substrate wafer, being a wafer covered by an insulating base layer. SiO₂ layers are produced on the top surfaces of the dies and subsequently the complete die surface is covered with a passivation layer. Next trenches are etched between the chips down to the insulating layer of the substrate (i.e. the insulating layer serves as a stop layer for the trench etching) for separating the chips. Spacers are produced subsequently for passivation at the side-walls of the chips. Then wafer material is removed by etching from the backside in order to detach the chips.

### Aims of the invention

It is an aim of the present invention to provide for a method for wafer dicing, which alleviates or avoids the problems of the prior art.

### Summary of the invention

The present invention according to claim 1 relates to a method for singulating at least one chip from a stack of layers, said stack comprising a front end of line (FEOL) upon a substrate layer, said substrate layer having a first and a second surface, said FEOL being positioned on top of said first surface, and a back end of line (BEOL) on top of said FEOL, said method comprising the steps of :
- etching singulating trenches through said BEOL, through said FEOL and at least partially through said substrate layer of said stack,
- depositing a passivation layer on said stack provided with singulating trenches, whereby also said trenches' sidewalls are at least partially passivated,
- releasing said chip from said stack of layers.
The above mentioned steps are preferably performed in the sequence as shown above.

In preferred embodiments the step of releasing said at least one chip comprises reducing the thickness of the substrate layer from the second surface onwards and at least in the region between the second surface and the bottom of the singulating trenches until the chip is released from the stack.

In another preferred embodiment at least two chips are singulated, and the step of etching trenches comprises etching two trenches between each two neighbouring chips. The step of releasing said chips then comprises a step of blade dicing, laser dicing or trench etch dicing between said two trenches. In such embodiments the area in between two such trenches can comprise metal dummies, test structures etc., which are not part of the dies or chips to be singulated. These areas may be not necessary anymore, e.g. after having performed testing, or may be of no real interest. Therefore blade dicing within this area can be performed, or possibly also trench etch dicing or laser dicing. In the case of blade dicing the trenches have the advantage that they relax stresses and may stop the propagation of cracks or other physical damage towards the chip areas.

In a preferred embodiment said BEOL is provided with metal dummies positioned outside a zone comprising the area of said chip and outside a metal exclusion zone around said chip area, wherein the presence of said metal dummies is excluded and wherein said step of etching said singulating trenches is performed.

Preferably the step of etching singulating trenches is performed in back end of line processing technology.

In another preferred embodiment the method further comprises a step of etching holes for interconnects in said chip area.

In an alternative embodiment damascene processing is performed for said BEOL.

Advantageously the step of etching singulating trenches comprises a step of using a mask with patterns corresponding to dies with rounded corners.

The present invention can be particularly advantageous if the BEOL comprises moisture-sensitive material.

### Short description of the drawings

Fig. 1 represents a prior art solution, whereby die singulation can be achieved by blade dicing, laser cutting or trench etch dicing.

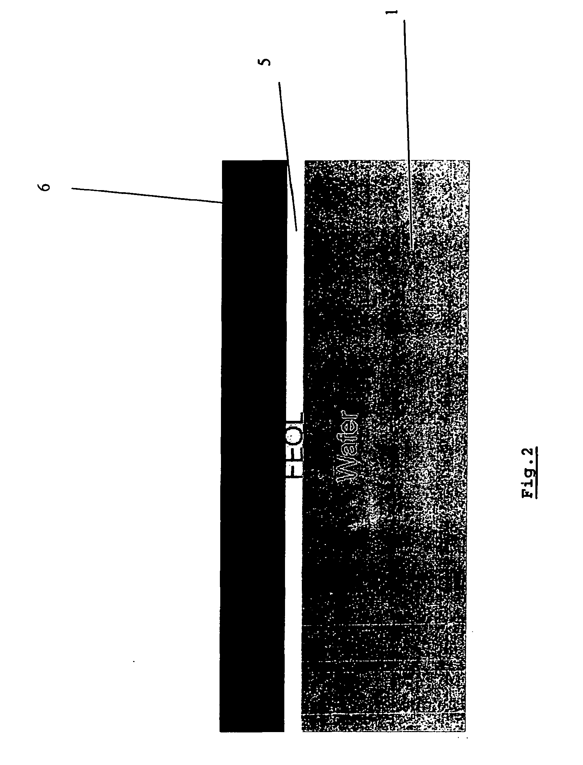

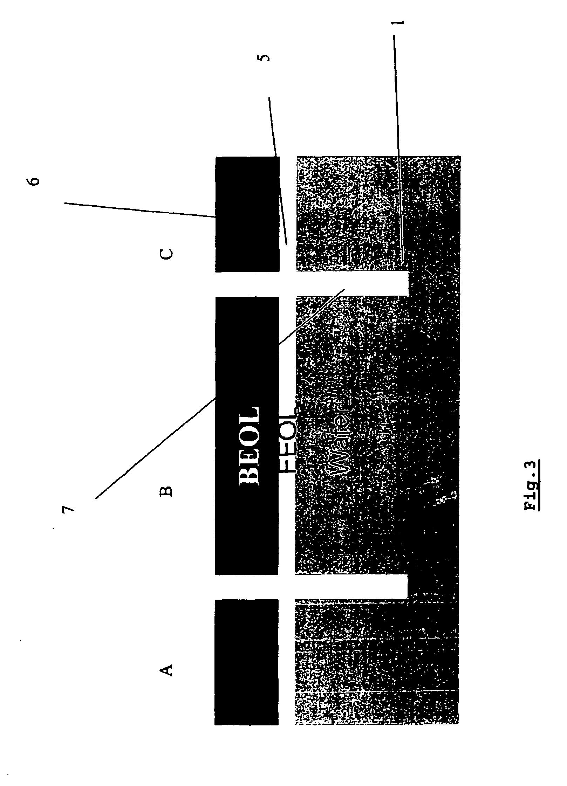

Fig. 2 to Fig.5 illustrate the various steps of the method according to a preferred embodiment of the present invention. Note that in Fig. 3 to Fig. 5 a schematic representation is given, comprising (indicated in Fig. 3) blocks A, B, C. According to certain embodiments, all of those blocks can correspond to dies. In an embodiment wherein at least two chips are singulated and wherein two trenches are etched between each two neighbouring chips, block B would not represent a chip but rather an area comprising metal dummies, test structures etc... These metal dummies, test structures, ... are not part of the dies or chips (represented by blocks A and C) to be singulated. Therefore blade dicing can be performed within this area, or possibly trench etch dicing or laser dicing.

Fig. 6 represents a cross sectional view of a prior art embodiment (left) compared to the embodiment according to the present invention (right). From the beginning, an exclusion zone is foreseen, comprising no metal dummies, around the chip areas. Here, by means of example, the exclusion zone is a collection of squares around the respective chips.

Fig. 7 represents a top view of the matter depicted in Fig. 6.

Fig. 8 shows another type of exclusion zone.

Fig. 9 represents some more examples of exclusion zones.

Fig. 10 shows an embodiment of the present invention, providing rounded vertical chip corner edges.

Fig. 11 represents an embodiment of the present invention whereby next to the etching of trenches aimed at chip singulation, additional features like holes are etched within the chip area.

### Detailed description of the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.

Furthermore, the terms first, second, third, and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under, and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

The present invention discloses a method for singulating chips from a stack of layers. The stack (see Fig.2) is obtained by first providing a substrate layer (1) having a first and a second surface. Then, on top of said first surface the front end of line (FEOL) (5) is processed and then the back end of line (BEOL) (6) is processed on said FEOL. The front end of line is commonly known as the layers in a semiconductor stack up to first interconnect metallisation level that contain active devices. The back end of line is commonly known as the layers in a semiconductor stack following the first metallisation level and before the passivation layer(s).

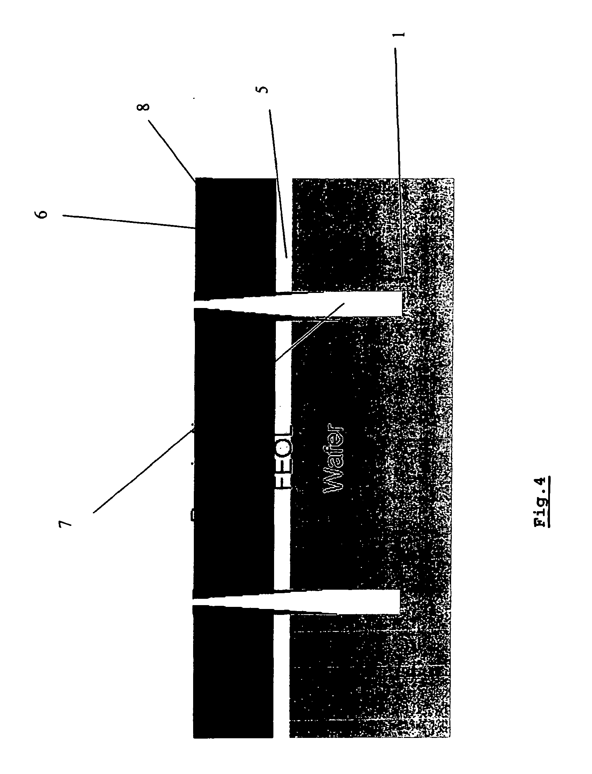

The method comprises the following steps :
- etching singulating trenches (7), hereby going through the BEOL, through the FEOL and at least partially through into said substrate (Fig.3),
- depositing a passivation layer (8) on the stack, now provided with singulating trenches (7), hereby passivating the upper surfaces of the chips to be singulated as well as the sidewalls of the singulating trenches that in a later stage will constitute the side surfaces of the chips (Fig.4),
- releasing at least one chip from said stack of layers.

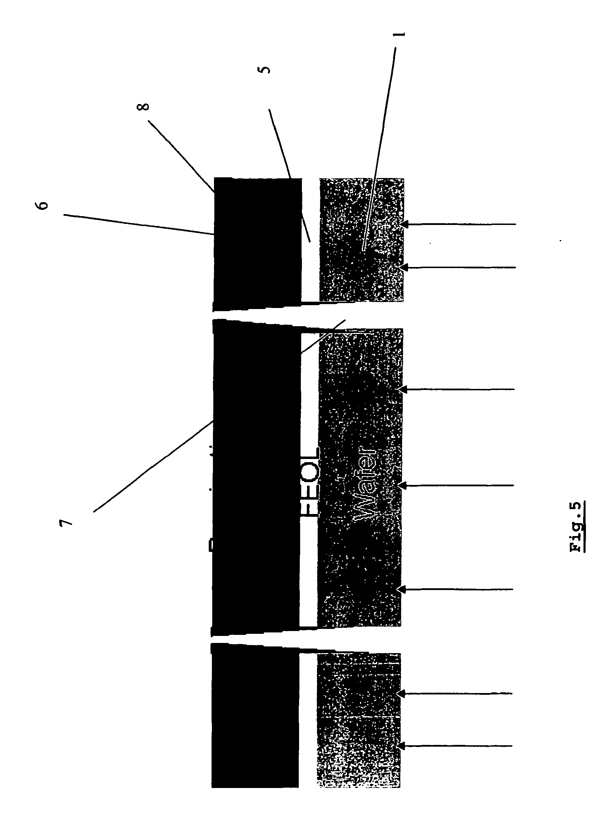

In a preferred embodiment the step of releasing at least one chip comprises reducing the thickness of the substrate layer from the second surface onwards (thus from the bottom side of the stack) and at least in the region between the second surface and the bottom of the singulating trenches, until the individual chips are released (Fig.5).

In another preferred embodiment at least two chips are singulated, and the step of etching trenches comprises etching two trenches between each two neighbouring chips. The step of releasing said chips then comprises a step of blade dicing, laser dicing or trench etch dicing between said two trenches. In such embodiment the area in between two such trenches can comprise metal dummies, test structures etc., which are not part of the dies or chips to be singulated. These areas may be not necessary anymore e.g. after having performed testing or may be of no real interest. Therefore blade dicing within this area can be performed, or if possible also trench etch dicing or laser dicing. In the case of blade dicing the trenches have the advantage that they relax stresses and may stop the propagation of cracks or other physical damage towards the chip areas.

A major advantage of the present invention is the presence of a step of depositing one or more passivation layers (8) on top of the stack after having provided singulating trenches. Hereby one passivates the upper surface or top of the stack comprising a chip to be singulated as well as the sidewalls or side surfaces of the chip. Hereby the sidewalls of the BEOL and the FEOL can be passivated. As already discussed, in the prior art the singulation process is performed completely after passivation, resulting in unpassivated sidewalls.

The passivation material is application dependent and can comprise for instance SiC, Silicon dioxide, Silicon Nitride, SiON, BenzoCycloButene (BCB) or a combination of these or other materials. The passivation layer can comprise different sublayers, made out of different materials. For instance the passivation layer can be a tri-layer. It can be for instance a SiC/ SiO₂ /SiN₄ layer as for instance 50 nm SiC / 330 nm SiO₂ / 500 nm SiN₄ for a copper process. For an Aluminium process it can be for instance a SiN₄ layer. The required minimum thickness depends on the sensitivity to contamination of the underlying chip. The passivation layer can be deposited by state of the art techniques as Physical Vapour Deposition (PVD) or Chemical Vapour deposition (CVD). Some materials (e.g. BCB) can be spun on.

This aspect of the present invention enhances the reliability of dies that incorporate moisture sensitive materials such as, but not only, low-K dielectrics and may eliminate the need for space consuming sealing rings (often referred to as a 'guard rings' or 'walls') around the die active area, as shown in prior art.

An additional step of typically temporarily attaching the stack of layers comprising singulation trenches to an adhesive film or foil before releasing the individual chips can be performed in another preferred embodiment.

The substrate can essentially be any substrate, which allows etching narrow trenches (1, 2, 3, 4, 5,10, 15, 20 µm wide for instance). It can be any semiconductor substrate, for instance, but not only, a silicon substrate, a GaAs substrate or a Germanium substrate. The layer at the top of the substrate (or on top of the substrate depending on the view), for instance Si substrate, or on top of the buried oxide in Silicon on Insulator (SOI) substrates in which transistors are built, is an active layer. Below the active layer the substrate (e.g. Si substrate) is present to provide mechanical support. The trenches should be deeper than the combined thickness of chip and active layer thickness in the substrate. They can be for instance between 20 and 100 or 200 µm deep.

The step of etching singulating trenches should be such that it can etch the back end of line, the front end of line and at least a part of the substrate. Dielectrics such as SiO₂, low-K materials, and barrier layers must possibly be etched. The etched trenches are preferably as narrow as possible, for instance 20 *µ*m or below (cfr.supra). The minimum width is determined by the applied technology. For certain passivation layers a minimum width is necessary though to allow the passivation layer to penetrate sufficiently deeply into the trenches to cover the sidewalls.

The step of reducing the thickness of the substrate from the bottom side of the stack can be for instance a polishing step as for instance a Chemical Mechanical Polishing (CMP) step, a grinding step or a substrate etch back. The final chip thickness is limited by the limitations of state of the art techniques. It can be for instance thinned up to 200, 175, 150, 130, 100, 90, 80, 70, 60, 50, 40, 30, 20, 10 *µ*m or less.

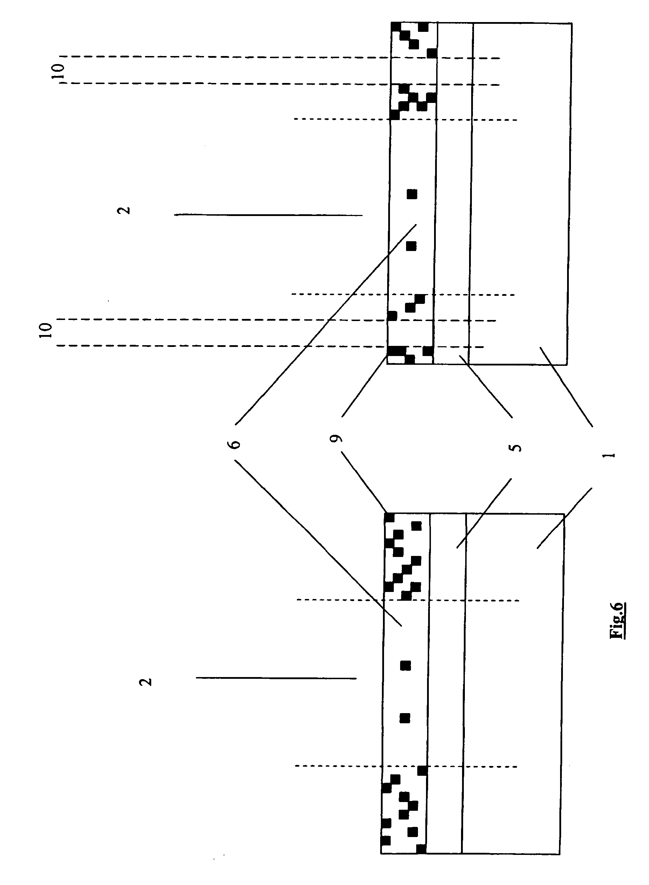

Certain aspects of the present invention more particularly refer to the field of damascene processing; hereby subtractive etch steps are performed in a deposited layer, followed by deposition of a metal and a flattening (e.g. polishing) step, after which a new layer can be deposited. In such processing typically metal (for instance copper) dummies (9) (Fig. 6) are processed at the same time with the processing of the BEOL, because of the well achievable uniformity after polishing during damascene processing. Damascene processing can be for instance Copper (Cu)-damascene, Aluminium (Al) damascene or Wolfram (W) Damascene. A special case of such damascene processing can be Cu/low-K applications.

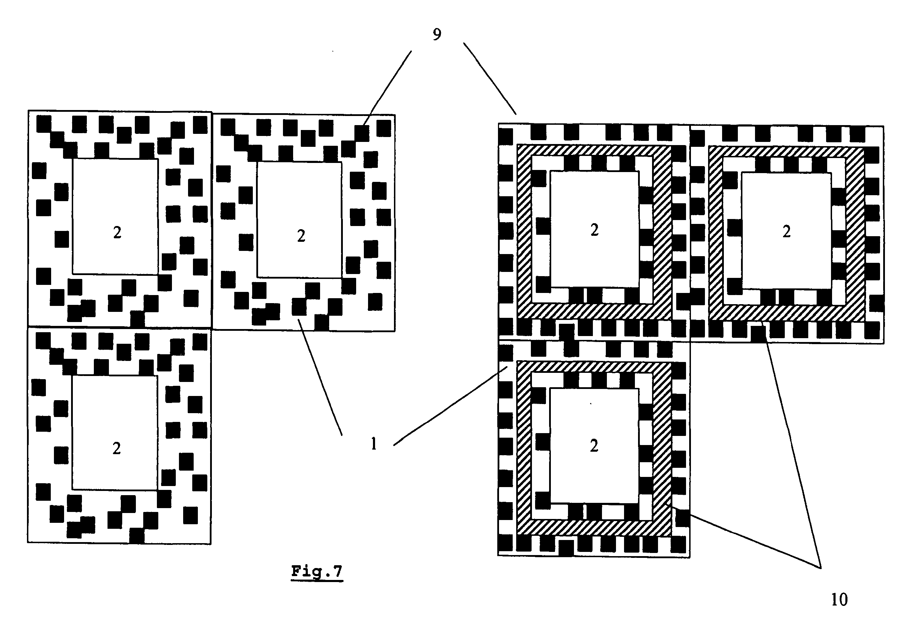

In typical damascene processing metal dummies are provided in the scribe lanes, such that they often cover the whole scribe lane area, when looked upon from above (see Fig. 6, left and Fig. 7, left).

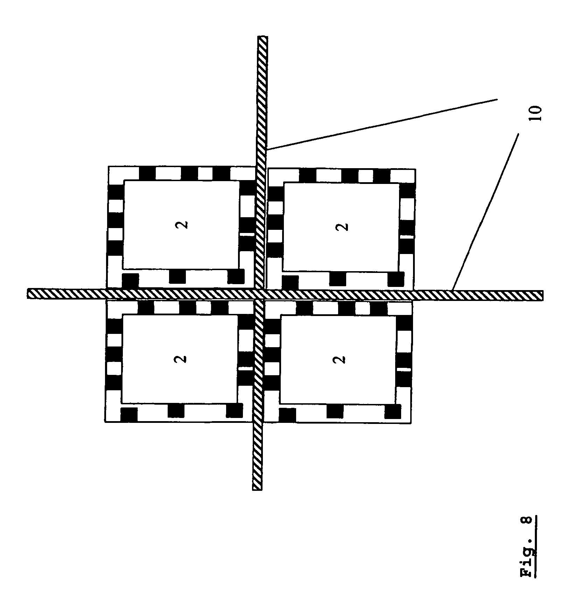

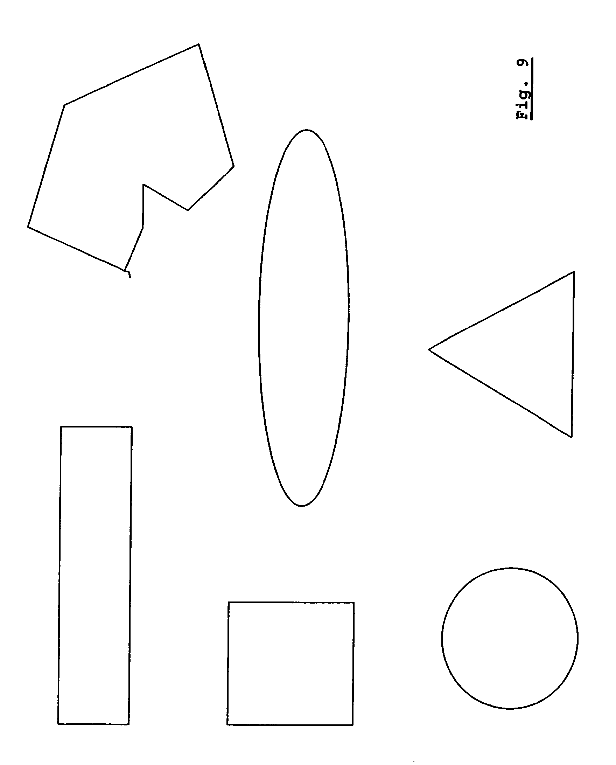

In an advantageous embodiment metal dummies are produced in the areas outside the area of the chip(s) during the BEOL processing. However, etching through metal is cumbersome. Therefore said metal dummies are positioned such that a metal exclusion zone (10) is foreseen, where no metal is present in any of the layers processed prior to etching the scribe lanes. The exclusion zone is placed around the chip area and is such that a line can be drawn in it that surrounds said chip area. In other words, it should enclose the chip area. The width of the exclusion zone may for instance be 15 *µ*m. So, when looking or projecting from above, a trench area is left open, where no metal is present. The exclusion zone is used for etching the singulating trenches (see Fig. 6, right side and Fig. 7, right side). The exclusion zone may be comprised in the scribe lanes between the die. The width of the singulating trenches and thus exclusion zone can be smaller than the size of the copper dummies or smaller than a typical inter dummy distance. The metal exclusion zone enables trench etch dicing for damascene processing. Fig.8 shows an alternative type of exclusion zone, whereby a lattice is formed between the chips. Fig.9 shows some more examples of exclusion zones, which preferably correspond to similarly shaped chips. In principle any form of exclusion zone and trench can be used.

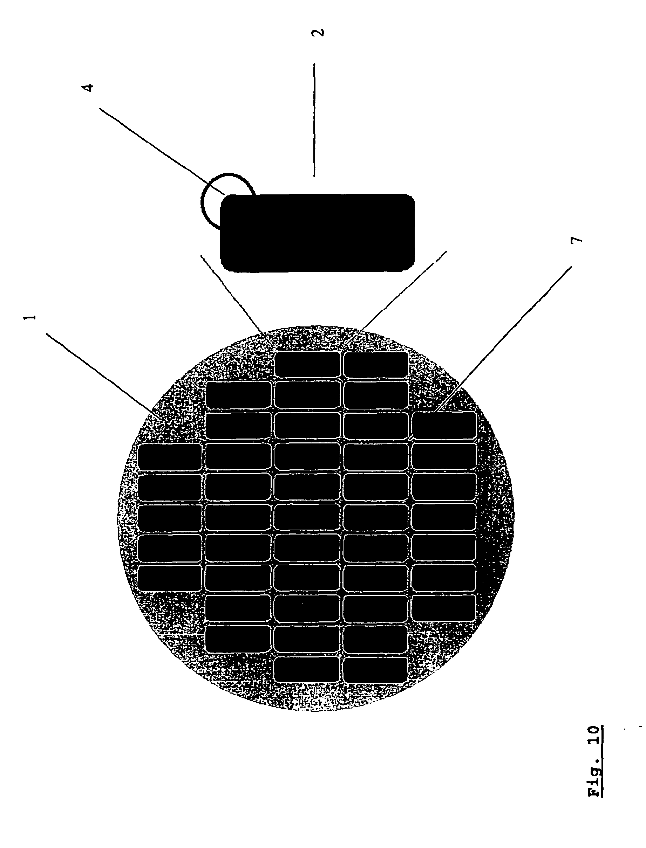

As a further advantage of the present invention, the step of providing singulating trenches can be chosen such that it produces rounded vertical chip corner edges (4) (Fig. 10). This can be achieved by performing the die singulation by exposing the wafer in a stepper or mask aligner with an image that defines the dicing streets and where, at crossover of different dicing streets, die corners are rounded. A mask with rounded die edges can be used for instance. This reduces the stress concentrations that occur near die corners (3) (see prior art, Fig.l). It is known by the person skilled in the art that alternatively masks with other shapes can be used to achieve dies with rounded corners. This is especially relevant for thin die, which are particularly sensitive to such stresses. Square die corners, as present in state of the art methods, lead to stress pile up especially in thin dies (for instance between 5 and 100 µm thick). Therefore the present invention provides for a reduction of stress sensitivity of the chips, resulting in a higher yield and reliability. This can be particularly advantageous for low-k applications.

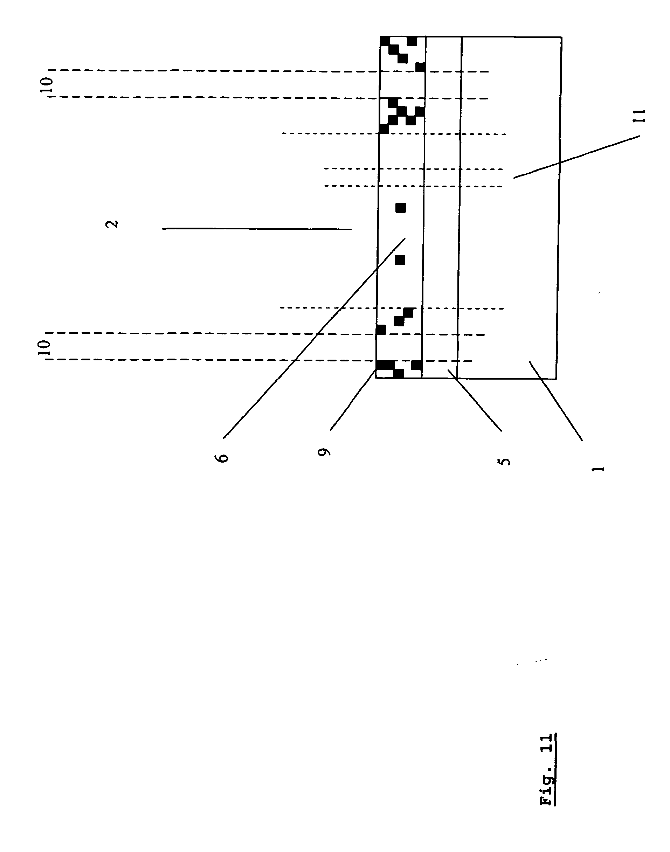

In a further embodiment (Fig.11) the method according to the present invention can comprise a step wherein additional features as holes (11) are etched within the chip area. Such holes may also be trenches (not be confused with singulating trenches!), which for instance, but not only, can be part of a MEMS device or serve as an isolation trench. During the flattening step these holes can also be reached, hereby creating through holes. Such through holes can be used for instance for electrical or optical interconnections. This step can be performed together with the step of etching singulation trenches, i.e. in the same technology.

## Claims

1. Method for singulating at least one chip from a stack of layers, said stack comprising a front end of line (FEOL) (5) upon a substrate layer (1), said substrate layer having a first and a second surface, said FEOL (5) being positioned on top of said first surface, and a back end of line (BEOL) (6) on top of said FEOL, said method comprising the steps of :
- etching singulating trenches through said BEOL (6), through said FEOL (5) and at least partially through said substrate layer (1) of said stack,
- depositing a passivation layer on said stack provided with singulating trenches, whereby also said trenches' sidewalls are at least partially passivated,
- releasing said at least one chip from said stack of layers.

2. Method for singulating a chip as in claim 1, wherein said step of releasing said at least one chip comprises reducing the thickness of said substrate layer from said second surface onwards and at least in the region between said second surface and the bottom of said singulating trenches until said at least one chip is released from said stack.

3. Method according to claim 1, wherein at least two chips are singulated, and wherein the step of etching trenches comprises etching two trenches between each two neighbouring chips and whereby the step of releasing said chips comprises a step of blade dicing, laser dicing or trench etch dicing between each of said two trenches.

4. Method for singulating at least one chip as in claim 1, wherein said BEOL (6) is provided with metal dummies positioned outside a zone comprising the area (2) of said chip and outside a metal exclusion zone (10) around said chip area (2), wherein the presence of said metal dummies is excluded and wherein said step of etching said singulating trenches is performed.

5. Method as in any of claims 1 to 3, wherein said step of etching singulating trenches is performed in back end of line professing technology.

6. Method as in any of the previous claims, wherein the step of etching singulation trenches further comprises a step of etching holes for interconnects in the area of said chip.

7. Method as in any of claims 2 to 6, wherein damascene processing is performed for said BEOL, whereby a subtractive etch step is performed in said BEOL, followed by a step wherein a metal is deposited and a flattening step.

8. Method as in any of the previous claims, wherein said step of etching singulating trenches comprises a step of using a mask with patterns corresponding to dies with rounded corners.

9. Method as in any of the previous claims, wherein said BEOL comprises moisture sensitive material.

## Patentansprüche

1. Verfahren zum Vereinzeln mindestens eines Chips von einem Stapel von Schichten, wobei der Stapel ein Front-End-of-Line (FEOL) (5) auf einer Substratschicht (1) umfasst, die Substratschicht eine erste und eine zweite Fläche aufweist, das FEOL (5) auf der Oberseite der ersten Fläche positioniert ist, und ein Back-End-of-Line (BEOL) (6) auf der Oberseite des FEOL, wobei das Verfahren die folgenden Schritte umfasst:
- ätzen von Vereinzelungsgräben durch das BEOL (6), durch das FEOL (5) und wenigstens teilweise durch die Substratschicht (1) des Stapels,
- deponieren einer Passivierungsschicht auf den Stapel der mit Vereinzelungsgräben versehen ist, wodurch außerdem die Seitenwände der Gräben wenigstens teilweise passiviert werden,
- lösen des mindestens einen Chips vom Stapel von Schichten.

2. Verfahren zum Vereinzeln eines Chips nach Anspruch 1, wobei der Schritt des Lösens des mindestens einen Chips ein Verringern der Dicke der Substratschicht von der zweiten Fläche vorwärts und wenigstens in der Region zwischen der zweiten Fläche und dem Boden der Vereinzelungsgräben umfasst bis der mindestens eine Chip vom Stapel gelöst wird.

3. Verfahren nach Anspruch 1, wobei mindestens zwei Chips vereinzelt werden, und wobei der Schritt des Ätzens von Gräben ein Ätzen von zwei Gräben zwischen jeweils zwei benachbarten Chips umfasst und wobei der Schritt des Lösens der Chips einen Schritt des Messerschneidens, Laserschneidens oder Grabenätzschneidens zwischen jedem der beiden Gräben umfasst.

4. Verfahren zum Vereinzeln mindestens eines Chips nach Anspruch 1, wobei das BEOL (6) mit Metallattrappen versehen ist die außerhalb einer Zone die den Bereich (2) des Chips umfasst und außerhalb einer Metallauschlusszone (10) um den Chipbereich (2) positioniert sind, wobei das Vorhandensein der Metallattrappen ausgeschlossen wird und wobei der Schritt des Ätzens der Vereinzelungsgräben durchgeführt wird.

5. Verfahren nach einem der Ansprüche 1 bis 3, wobei der Schritt des Ätzens von Vereinzelungsgräben in Back-End-of-Line-Verarbeitungstechnik durchgeführt wird.

6. Verfahren nach einem der vorhergehenden Ansprüche, wobei der Schritt des Ätzens von Vereinzelungsgräben ferner den Schritt des Ätzens von Löchern für Zwischenverbindungen im Bereich des Chips umfasst.

7. Verfahren nach einem der Ansprüche 2 bis 6, wobei Damascene-Verarbeitung für das BEOL durchgeführt wird, wodurch ein Schritt des subtraktiven Ätzens im BEOL ausgeführt wird, gefolgt von einem Schritt wobei ein Metall deponiert wird und einem Abflachungsschritt.

8. Verfahren nach einem der vorhergehenden Ansprüche, wobei der Schritt des Ätzens von Vereinzelungsgräben einen Schritt des Verwendens einer Maske mit Mustern umfasst entsprechend Chips mit abgerundeten Ecken.

9. Verfahren nach einem der vorhergehenden Ansprüche, wobei das BEOL feuchtigkeitsempfindliches Material umfasst.

## Revendications

1. Procédé de séparation d'au moins une puce d'une pile de couches, ladite pile comprenant une extrémité avant de ligne (FEOL) (5) sur une couche de substrat (1), ladite couche de substrat comportant une première et une deuxième surface, ladite FEOL (5) étant positionnée sur ladite première surface, et une extrémité arrière de ligne (BEOL) (6) sur ladite FEOL, ledit procédé comprenant les étapes de:
- gravure de tranchées de séparation à travers ladite BEOL (6), à travers ladite FEOL (5) et au moins partiellement à travers ladite couche de substrat (1) de ladite pile,
- dépôt d'une couche de passivation sur ladite pile pourvue de tranchées de séparation, par lequel les parois latérales desdites tranchées sont également au moins partiellement passivées,
- libération de ladite au moins une puce de ladite pile de couches.

2. Procédé de séparation d'une puce selon la revendication 1, dans lequel ladite étape de libération de ladite au moins une puce comprend la réduction de l'épaisseur de ladite couche de substrat à partir de ladite deuxième surface et au moins dans la région entre ladite deuxième surface et le fond desdites tranchées de séparation jusqu'à ce que ladite au moins une puce soit libérée de ladite pile.

3. Procédé selon la revendication 1, dans lequel au moins deux puces sont séparées, et dans lequel l'étape de gravure de tranchées comprend la gravure de deux tranchées entre chacune de deux puces voisines et par lequel l'étape de libération desdites puces comprend une étape de découpe à la lame, de découpe au laser ou de découpe par gravure de tranchée entre chacune desdites deux tranchées.

4. Procédé de séparation d'au moins une puce selon la revendication 1, dans lequel ladite BEOL (6) est pourvue de pièces factices métalliques positionnées en-dehors d'une zone comprenant l'aire (2) de ladite puce et en-dehors d'une zone d'exclusion de métal (10) autour de ladite aire de puce (2), dans laquelle la présence desdites pièces factices métalliques est exclue et dans laquelle ladite étape de gravure desdites tranchées de séparation est effectuée.

5. Procédé selon l'une quelconque des revendications 1 à 3, dans lequel ladite étape de gravure de tranchées de séparation est effectuée dans la technologie de traitement d'extrémité arrière de ligne.

6. Procédé selon l'une quelconque des revendications précédentes, dans lequel l'étape de gravure de tranchées de séparation comprend en outre une étape de gravure de trous pour des interconnexions dans l'aire de ladite puce.

7. Procédé selon l'une quelconque des revendications 2 à 6, dans lequel un traitement de damasquinage est effectué pour ladite BEOL, par lequel une étape de gravure soustractive est effectuée dans ladite BEOL, suivie d'une étape au cours de laquelle un métal est déposé et d'une étape d'aplatissement.

8. Procédé selon l'une quelconque des revendications précédentes, dans lequel ladite étape de gravure de tranchées de séparation comprend une étape d'utilisation d'un masque avec des motifs correspondant à des puces avec des coins arrondis.

9. Procédé selon l'une quelconque des revendications précédentes, dans lequel ladite BEOL comprend un matériau sensible à l'humidité.
